# EUROPÄISCHE PATENTANMELDUNG

(11) **EP 4 635 777 A1**
(43) Veröffentlichungstag der Anmeldung: **22.10.2025**
(21) Anmeldenummer: 25170522.4
(22) Anmeldetag: 15.04.2025
(51) Int. Cl.: B60L 3/00, B60L 53/16, G01R 27/02

(54) **MESSUNG EINES ISOLATIONSWIDERSTANDES EINES BORDNETZES EINES ELEKTROFAHRZEUGS**

(30) Priorität: 16.04.2024 AT 503172024
(71) Anmelder: AVL DiTest GmbH, 8020 Graz (AT)
(72) Erfinder: Schwaiger, Patrik, 8542 Deutschlandsberg (AT); Huber, Christian, 8045 Graz (AT); Schulz, Jonas, 8041 Graz (AT)
(74) Vertreter: Patentanwälte Pinter & Weiss OG

(57) **Zusammenfassung**

Um einen wirksamen Isolationswiderstand der elektrischen Isolation eines Hochvolt-Bordnetzes (2) eines Elektrofahrzeuges (1) einfach und sicher zu messen, ist vorgesehen, dass ein Ladestecker (8) eines Messgerätes (10) in eine Ladebuchse (7) des Elektrofahrzeugs (1) gesteckt wird, dann ein Ladevorganges des Elektrofahrzeugs (1) mit dem Messgerät initialisiert wird, und nach dem Initialisieren des Ladevorganges der wirksame Isolationswiderstandes (Rw) zwischen zumindest einem Ladespannungskontakt (DC+, DC-) des Ladesteckers (7) und einem Referenzspannungskontakt (PE) des Ladesteckers gemessen wird.

## Beschreibung

Die gegenständliche Erfindung betrifft ein Verfahren zur Durchführung einer Messung eines wirksamen Isolationswiderstandes eines Hochvolt-Bordnetzes eines Elektrofahrzeugs. Die Erfindung betrifft auch eine Anordnung zum Messen eines wirksamen Isolationswiderstandes eines Hochvolt-Bordnetzes eines Elektrofahrzeugs.

Die elektrische Isolation des Hochvoltsystems bei Elektrofahrzeugen, worunter im Rahmen dieser Anmeldung sowohl reine Elektrofahrzeuge als auch Hybridfahrzeuge verstanden werden, ist eine wichtige Sicherheitseinrichtung. Ein elektrischer Isolationswiderstand ist ein Merkmal der elektrischen Isolation. Die elektrische Isolation eines Elektrofahrzeuges muss daher regelmäßig überprüft werden, beispielsweise im Rahmen der regelmäßigen Fahrzeugüberprüfung in einer Werkstätte. Der ohmsche Widerstand zwischen den aktiven Leitern (DC+ und DC-) des Hochvoltsystems und der Fahrzeugkarosserie des Fahrzeugs ist ein wesentliches Merkmal dieser elektrischen Isolation. Dieser ohmsche Widerstand wird auch als Isolationswiderstand bezeichnet.

Um die Gesamtisolation des Elektrofahrzeugs zu messen, muss sowohl der Isolationswiderstand der passiven Hochvolt (HV)-Komponenten des Elektrofahrzeugs, wie z.B. Klimakompressor, Heizer, Wechselrichter usw., als auch der Isolationswiderstand des elektrischen Speichers im Elektrofahrzeug gemessen werden. Dazu muss das HV-System im Elektrofahrzeug aktiv sein und der elektrische Speicher mit den HV-Komponenten elektrisch verbunden sein.

Es sind viele Methoden bekannt, um eine Gesamtisolationsmessung am aktiven HV-System durchzuführen (z.B. in SAE J1766, ISO 6469-1, ECE-R100). Die im Fahrzeug verbauten Isolationsüberwachungsgeräte (Insulation-Monitor-Device, IMD) arbeiten nach diesen etablierten Methoden. Ein IMD ermittelt den Isolationswiderstand während des Betriebs des Fahrzeugs. In Rahmen einer Werkstättenüberprüfung kann das IMD aber nicht genutzt werden, weil das Fahrzeug und insbesondere das HV-System des Fahrzeugs in der Werkstatt inaktiv ist.

Im Rahmen einer Werkstättenüberprüfung ist es daher erforderlich, den Isolationswiderstand mit einem externen Messgerät zu messen. Möchte man die Gesamtisolation des Fahrzeugs mit einem externen Messgerät überprüfen, so steht man aber vor wesentlichen Herausforderungen. Zum einen besteht das Problem der Zugänglichkeit des HV-Systems von außen, um das HV-System überhaupt mit einem externen Messgerät kontaktieren zu können, ohne dabei die Isolationsmessung zu verfälschen. Dieses Problem wird nach aktuellem Stand der Technik entweder durch Freilegen der Hochvoltkontakte (kein Berührschutz) oder durch spezielle Messadapter (mit Berührschutz) gelöst. In beiden Fällen ist ein Montageeingriff in das Fahrzeug notwendig. Im ersten Fall besteht ein hochgradiges Sicherheitsproblem für die Person, die die Messung durchführt, da kein Berührschutz gegeben ist. Daher muss die Person persönliche Schutzausrüstung tragen, insbesondere Isolierhandschuhe, Helm mit Visier, Sicherheitsschuhe und elektrische Schutzkleidung. Das ist im Werkstättenbetrieb kaum realisierbar. Im anderen Fall müssen fahrzeugspezifische Messadapter verwendet werden. Damit muss in der Werkstätte für jedes Fahrzeug ein passender Messadapter vorhanden sein. Der Messadapter muss dazu noch vor der Messung am Fahrzeug angebracht werden. Auch das macht den Einsatz im Werkstättenbetrieb äußert umständlich und aufwendig. Ein anderes Problem bei einer Isolationswiderstandsmessung besteht darin, dass bei aktiviertem HV-System der fahrzeuginterne IMD aktiv ist. Das führt dazu, dass mit einem externen Messgerät der Messwert des Isolationswiderstandes verfälscht oder schwer oder gar nicht ermittelt werden kann.

Es besteht damit Bedarf an einer einfachen externen Messung des Isolationswiderstand am HV-Bordnetz eines Elektrofahrzeugs.

Diese Aufgabe wird dadurch gelöst, in dem zuerst ein Ladestecker in eine Ladebuchse des Elektrofahrzeugs gesteckt, dann ein Ladevorganges des Elektrofahrzeugs initialisiert wird, und nach dem Initialisieren des Ladevorganges, der wirksame Isolationswiderstand zwischen zumindest einem Ladespannungskontakt des Ladesteckers und einem Referenzspannungskontakt des Ladesteckers gemessen wird. Vorzugsweise wird zwischen allen Ladespannungskontakten und dem Referenzspannungskontakt der Isolationswiderstand gemessen.

Durch das Initialisieren des Ladevorganges wird das Elektrofahrzeug dazu veranlasst, Schalter, die die Ladebuchse vom Hochvolt-Bordnetz trennen, zu schließen. Das ermöglicht, die Messung des wirksamen Isolationswiderstandes über den Ladestecker. Damit sind keine Messadapter erforderlich, sondern es kann ein standardisierter Ladestecker, der für eine Vielzahl von Elektrofahrzeugen gleich ist, verwendet werden. Ebenso stellt diese Art der Messung den Berührschutz für die die Messung durchführende Person sicher, womit die Personensicherheit gegeben ist. Dieses Verfahren ist aufgrund der einfachen Handhabung insbesondere für eine Überprüfung des wirksamen Isolationswiderstandes in einer Werkstätte geeignet.

Der Ladevorgang wird vorteilhaft über Steuerkontakte am Ladestecker, die durch Stecken des Ladestecker in die Ladebuchse mit Steuerkontakten der Ladebuchse verbunden werden, und einem vorgegebenen Ladeprotokoll initialisiert. Damit kann auf das normale Ladeprotokoll des Elektrofahrzeugs zurückgegriffen werden. Bedarfsweise kann zum Initialisieren des Ladevorganges zusätzlich eine Ladespannung zwischen dem ersten Ladespannungskontakt und dem zweiten Ladespannungskontakt des Ladesteckers angelegt werden.

Wird zum Initialisieren des Ladevorganges eine Ladespannung angelegt, dann wird die Ladespannung vor dem Messen des wirksamen Isolationswiderstandes vorteilhaft weggeschaltet, um eine Überlagerung der Ladespannung mit der Batteriespannung im Elektrofahrzeug während der Messung zu vermeiden.

Wird vor dem Initialisieren des Ladevorganges ein wirksamer Isolationswiderstandes zwischen zumindest einem Ladespannungskontakt des Ladesteckers und einem Referenzspannungskontakt des Ladesteckers gemessen, kann auch ein mögliches Feuchtigkeitsproblem in der Ladebuchse, was die elektrische Isolation beeinträchtigen kann, erkannt werden.

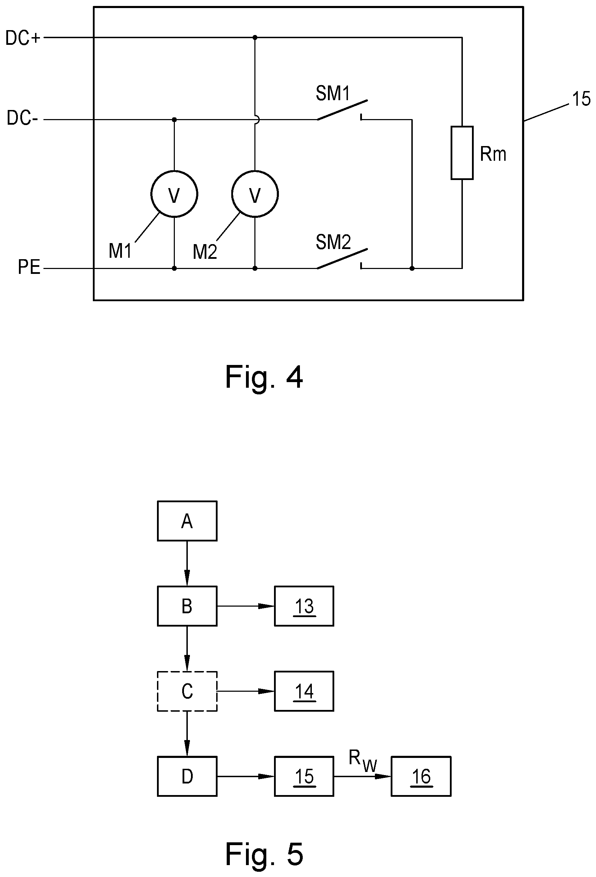

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig.1 eine Ausführung eines Hochvolt-Bordnetzes eines Elektrofahrzeugs,
Fig.2 ein Messgerät zur Durchführung des erfindungsgemäßen Messverfahrens zur Messung des wirksamen Isolationswiderstandes eines Elektrofahrzeugs,
Fig.3 eine mögliche Ausführung eines Kommunikationsmoduls des Messgeräts,
Fig.4 eine mögliche Ausführung eines Messmoduls des Messgeräts und
Fig.5 den erfindungsgemäßen Ablauf zum Messen des wirksamen Isolationswiderstandes.

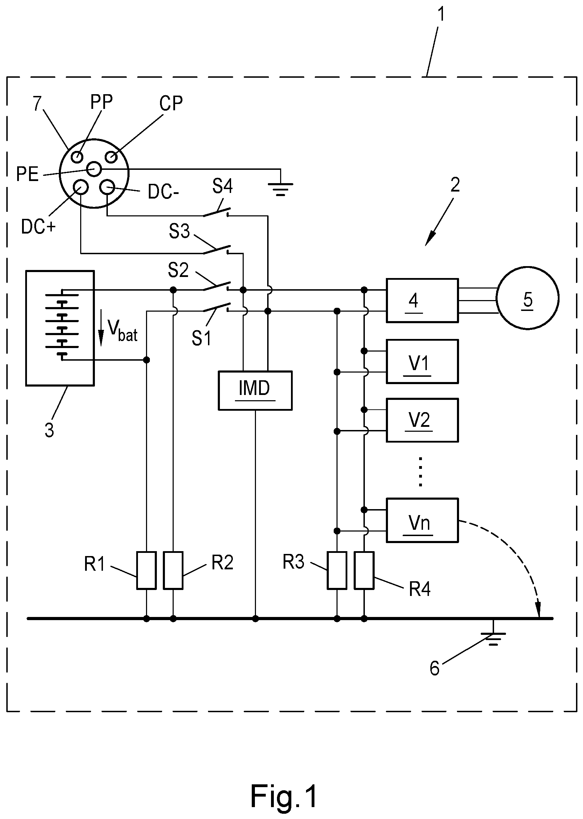

Fig.1 zeigt eine typische Konfiguration eines Hochvolt-Bordnetzes 2 eines Elektrofahrzeugs 1. Unter einem Elektrofahrzeug werden im Rahmen der Erfindung sowohl reine Elektrofahrzeuge, als auch Hybridfahrzeuge verstanden.

Das Hochvolt-Bordnetz 2 des Elektrofahrzeugs 1 umfasst eine elektrische Speicherbatterie 3, zumindest einen (oftmals bidirektionalen) Wechselrichter 4, der mit der Speicherbatterie 3 verbunden ist, und zumindest einen Elektromotor 5, der mit dem Wechselrichter 4 verbunden ist. Der Wechselrichter 4 wandelt im Betrieb des Elektrofahrzeugs 1 eine Gleichstrom (DC) Batteriespannung V_{bat} in eine Wechselstrom (AC) Motorspannung vₘₒₜ, um damit den Elektromotor 5 anzusteuern. Im Falle von Rekuperation, kann der Elektromotor 5 auch als Generator betrieben werden und der bidirektionale Wechselrichter 4 kann elektrische Energie in die Speicherbatterie 3 einspeisen.

Im Hochvolt-Bordnetz 2 sind neben dem Wechselrichter 4 üblicherweise noch andere elektrische Verbraucher Vn, wie ein Klimakompressor, eine elektrische Heizung, zusätzliche Spannungswandler usw., vorhanden. "n" ist dabei als Index zu verstehen, der verwendet wird, wenn die Verbraucher allgemein referenziert werden und kein spezifischer Verbraucher. Die Verbraucher Vn sind ebenfalls mit der Speicherbatterie 3 verbunden und werden aus der Speicherbatterie 3 mit elektrischer Energie versorgt.

Aus Sicherheitsgründen sind die elektrischen Komponenten des Hochvolt-Bordnetzes 2 über hochohmige Isolationswiderstände R1, R2, R3, R4 mit einem elektrischer Referenzpunkt 6 des Elektrofahrzeugs 1 verbunden. Wird allgemein ein Isolationswiderstand referenziert, wird auch Ri mit dem Index "i" verwendet. In einem Elektrofahrzeug 1 dient üblicherweise die Fahrzeugkarosserie als elektrischer Referenzpunkt (Masse) 6. Alle elektrischen Geräte im Elektrofahrzeug 1 sind auf diesen Referenzpunkt 6 bezogen angeschlossen. Über die Isolationswiderstände Ri ist das Hochvolt-Bordnetz 2 ebenfalls mit dem elektrischen Referenzpunkt 6 verbunden. Die hochohmigen Isolationswiderstände Ri sorgen bei ordnungsgemäßem Zustand des Elektrofahrzeugs 1 dafür, dass am elektrischen Referenzpunkt 6 (und damit an der Fahrzeugkarosserie, die berührt werden kann) keine Hochvolt-Spannung anliegt. Bei Fehlern, kann sich aber der tatsächlich wirksame Isolationswiderstand ändern. Der wirksame Isolationswiderstand im Elektrofahrzeug 1 muss daher regelmäßig kontrolliert werden.

In der Ausführung nach Fig.1 ist ein fahrzeuginternes Isolationsüberwachungsgerät IMD dargestellt, das im laufenden Betrieb des Elektrofahrzeugs 1 laufend den wirksamen Isolationswiderstand misst und beispielsweise an eine Fahrzeugsteuereinheit zur weiteren Auswertung übergibt.

Aufgrund von Alterung und Verschleiß kann sich die elektrische Isolation verschlechtern, sodass der tatsächlich wirksame Isolationswiderstand im Elektrofahrzeug 1 sinkt. Das kann praktisch an jeder Stelle passieren, beispielsweise kann sich die elektrische Isolation zwischen Verbraucher Vn und elektrischem Referenzpunkt 6 schleichend verschlechtern, was in Fig.1 durch die gestrichelte Linie beim Verbraucher Vn angedeutet ist. Das beeinflusst natürlich den (beispielsweise mit dem Isolationsüberwachungsgerät IMD) gemessenen Isolationswiderstand, in der Regel dadurch, dass der gemessene Isolationswiderstand sinkt.

Im Hochvolt-Bordnetz 2 des Elektrofahrzeugs 1 sind auch Schalter S1, S2, S3, S4, wie ein Schütz oder Relais, vorgesehen. Wird allgemein ein Schalter referenziert wird auch Sj mit dem Index "j" verwendet. Hierbei dienen erste Schalter S1, S2 dazu, die Speicherbatterie 3 bedarfsweise vom Rest des Hochvolt-Bordnetzes 2 zu trennen und zweite Schalter S3, S4 dazu, eine Ladebuchse 7 des Elektrofahrzeugs 1 bedarfsweise vom Rest des Hochvolt-Bordnetzes 2 zu trennen. Ist das Elektrofahrzeug 1 inaktiv, dann sind die Schalter Sj offen, insbesondere die zweiten Schalter S3, S4 zum Trennen der Ladebuchse 7, und bei einem aktivierten Elektrofahrzeug 1 geschlossen. Die zweiten Schalter S3, S4, die die Ladebuchse 7 mit dem Hochvolt-Bordnetz 2 verbinden sind üblicherweise nur im Falle eines Ladevorganges geschlossen.

Über die Ladebuchse 7 wird in bekannter Weise ein Ladestecker 8 angesteckt, um das Elektrofahrzeug 1, konkret die Speicherbatterie 3 des Elektrofahrzeugs 1, von extern zu laden.

Die Ladebuchse 7 hat hierfür mehrere standardisierte Kontakte. Zum einen sind an der Ladebuchse 7 ein erster Ladespannungskontakt DC+ und ein zweiter Ladespannungskontakt DC-, sowie ein Referenzspannungskontakt PE vorgesehen. Der Referenzspannungskontakt PE ist im Elektrofahrzeug 1 mit dem elektrischen Referenzpunkt 6 verbunden. Außerdem sind zwei Steuerkontakte PP, CP vorgesehen, die der Kommunikation des Ladegeräts mit dem Elektrofahrzeug 1 dienen. Über ein ebenfalls standardisiertes Ladekommunikationsprotokoll wird ein Ladevorgang am Elektrofahrzeug 1 initiiert, durchgeführt und überwacht. Hierzu tauschen das Ladegerät und das Elektrofahrzeug 1 Nachrichten gemäß einem Ladeprotokoll aus.

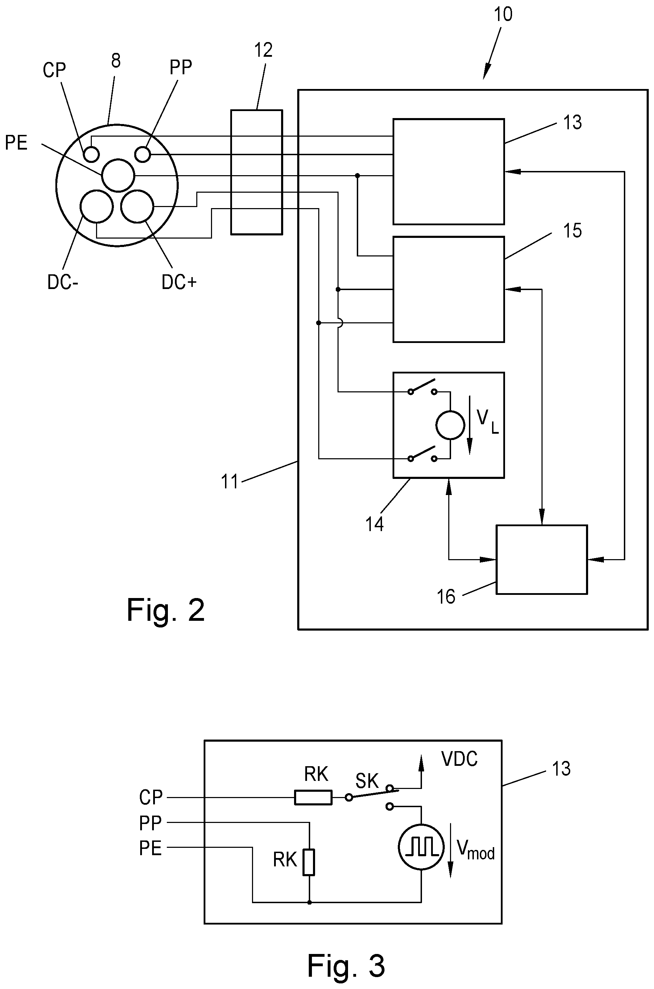

In Fig.2 ist das erfindungsgemäße Messgerät 10 zur externen Messung des wirksamen Isolationswiderstandes R_{W} im Hochvolt-Bordnetz 2 des Elektrofahrzeugs 1 dargestellt.

Das Messgerät 10 umfasst den Ladestecker 8 und eine Messeinheit 11. Der Ladestecker 8 hat natürlich zur Ladebuchse 7 des Elektrofahrzeugs 1 komplementäre Kontakte. Die Kontakte an der Ladebuchse 7 sind üblicherweise männlich und am Ladestecker 8 weiblich. Der Ladestecker 8 ist über ein Ladekabel 12 mit der Messeinheit 11 verbunden. Im Ladekabel 12 sind Leitungen vorgesehen, um die einzelnen Kontakte des Ladesteckers 8 mit der Messeinheit 11 zu verbinden. Die einzelnen Leitungen im Ladekabel 12 werden bedarfsweise entsprechend der Bezeichnung des jeweiligen Kontaktes im Ladestecker 8 bezeichnet. Die Ladebuchse 7 und der Ladestecker 8 sind üblicherweise standardisiert.

Die Messeinheit 11 umfasst verschiedene Funktionsmodule, die in Fig.2 mit einzelnen Blöcken dargestellt sind. Das dient aber nur der Beschreibung und ist nicht einschränkend hinsichtlich des Hardwareaufbaus oder Schaltungsaufbaus in der Messeinheit 11 zu verstehen.

Ein Kommunikationsmodul 13 ist über Steuerleitungen mit den Steuerkontakten PP, CP am Ladestecker 8 verbunden, und auch mit dem Referenzspannungskontakt PE. Das Kommunikationsmodul 13 dient dazu, einen Ladevorgang mit dem Elektrofahrzeug 1 zu initialisieren, um dem Elektrofahrzeug 1 einen Ladevorgang mit einem Ladegerät vorzumachen. Hierfür implementiert das Kommunikationsmodul 13 das jeweilige standardisierte Ladeprotokoll und erzeugt und sendet die entsprechenden Nachrichten an das Elektrofahrzeug 1 und werten die Nachrichten vom Elektrofahrzeug 1 erhaltenen Nachrichten aus.

Üblicherweise erfordert das Initialisieren eines Ladevorganges auch eine anliegende Ladespannung an den Ladespannungskontakten DC+, DC-. Hierfür ist ein Ladespannungsmodul 14 vorgesehen, der die benötigte Ladespannung erzeugt und zwischen den Ladespannungskontakten DC+, DC- anlegt. Das Ladespannungsmodul 14 ist daher über Ladespannungsleitungen mit dem ersten Ladespannungskontakt DC+ und dem zweiten Ladespannungskontakt DC- am Ladestecker 8 verbunden. Falls für das Initialisieren eines Ladevorgangs keine anliegende Ladespannung benötigt wird, dann könnte das Ladespannungsmodul 14 auch entfallen oder inaktiv sein.

In der Messeinheit 11 ist ferner ein Messmodul 15 vorgesehen, das mit den Ladespannungskontakten DC+, DC- und dem Referenzspannungskontakt PE am Ladestecker 8 verbunden ist. Das Messmodul 15 misst die Spannung zwischen erstem Ladespannungskontakt DC+ und dem Referenzspannungskontakt PE und/oder zwischen zweitem Ladespannungskontakt DC- und dem Referenzspannungskontakt PE und leitet daraus den wirksamen Isolationswiderstand R_{w} im Hochvolt-Bordnetz 2 des Elektrofahrzeugs 1 ab. Das ist deshalb möglich, weil das Messmodul 15 über den Ladestecker 8 und der Ladebuchse 7 mit dem Hochvolt-Bordnetz 2 verbunden ist und damit an den Ladespannungskontakten DC+, DC- die Hochvolt-Spannung im Hochvolt-Bordnetz 2 anliegt. Zur Widerstandsmessung kann im Messmodul 15 zusätzlich auch eine Strommessung implementiert sein. Wie die Widerstandsmessung im Messmodul 15 konkret implementiert ist, spielt für die Erfindung allerdings keine Rolle.

Nicht zuletzt ist in der Messeinheit 11 auch eine Steuereinheit 16 vorgesehen, die mit den einzelnen Funktionsmodulen, wie Kommunikationsmodul 13, Messmodul 15 und gegebenenfalls auch Ladespannungsmodul 14, verbunden ist und diese steuert. Das Messmodul 15 liefert einen den wirksamen Isolationswiderstand repräsentierenden Wert an die Steuereinheit 16. Der den wirksamen Isolationswiderstand repräsentierende Wert kann der wirksame Isolationswiderstand R_{W} selbst sein, wenn das Messmodul 11 die entsprechende Auswertung macht, oder kann auch ein Spannungsmesswert und/oder Strommesswert, oder auch eine andere elektrische Größe, sein, wenn die Steuereinheit 16 den wirksamen Isolationswiderstand R_{W} bestimmt.

Die Steuereinheit 16 ist üblicherweise als mikroprozessorbasierte Hardware, beispielsweise als Mikrocontroller, ausgeführt, mit darauf ablaufender Steuersoftware.

Natürlich kann am Messgerät 10, beispielsweise an der Messeinheit 11, auch eine Ausgabeeinheit, wie eine Anzeige, Signalleuchten usw., vorgesehen sein, um den gemessenen wirksamen Isolationswiderstand R_{W} auszugeben oder eine hinreichende Isolation anzuzeigen. Am Messgerät 10, beispielsweise an der Messeinheit 11, kann auch eine Kommunikationsschnittstelle vorgesehen sein, um den gemessenen wirksamen Isolationswiderstand R_{W} kabelgebunden oder kabellos an ein anderes Gerät zu übertragen.

Eine mögliche Implementierung des Kommunikationsmodul 13 ist in Fig.3 dargestellt. Über einen Schalter SK, der beispielsweise von der Steuereinheit 16 angesteuert wird, und optionale Widerstände RK (die nicht gleich sein müssen) wird entweder eine Versorgungspannung VDC, beispielsweise 12V Gleichspannung, an den Steuerkontakt CP angelegt, oder eine modulierte Spannung V_{mod}, beispielsweise ±12V Wechselspannung mit einer vorgegebenen Frequenz (wie z.B. 1kHz), angelegt. Durch entsprechende Modulation der modulierten Spannung V_{mod}, wie Pulsweitenmodulation oder Frequenzmodulation oder Amplitudenmodulation, wird das vorgegebene Ladeprotokoll implementiert. Die Art der Modulation wird dabei durch das vorgegebene Ladeprotokoll vorgegeben.

Im Ladespannungsmodul 14 ist beispielsweise eine schaltbare Spannungsquelle vorgesehen (wie in Fig.1), die die vorgegebene Ladespannung V_{L} erzeugt und bedarfsweise, beispielsweise über Schalter, die von der Steuereinheit 16 angesteuert werden, an die Ladespannungskontakte DC+, DC- angelegt wird.

Im Messmodul 15 ist beispielsweise ein Messwiderstand Rm vorgesehen, der über Schalter SM1, SM2, die von der Steuereinheit 16 angesteuert sein können, entweder zwischen den ersten Ladespannungskontakt DC+ und dem Referenzspannungskontakt PE oder zwischen den zweiten Ladespannungskontakt DC- und dem Referenzspannungskontakt PE geschaltet werden kann. Damit kann über Spannungssensoren M1, M2 die jeweilige Spannung gemessen werden. Im Messmodul 15 könnte auch ein Stromsensor vorgesehen, um einen, beispielsweise durch den Messwiderstand Rm, fließenden elektrischen Strom zu messen.

Um mit dem Messgerät 10 den im Hochvolt-Bordnetz 2 des Elektrofahrzeugs 1 wirksamen Isolationswiderstand R_{W} bei inaktivem Elektrofahrzeug 1 zu messen, wird mit Bezugnahme auf Fig.6 wie folgt vorgegangen.

In einem ersten Schritt A wird das Messgerät 10 über den Ladestecker 8 mit der Ladebuchse 7 des Elektrofahrzeugs 1 verbunden. Im folgenden Schritt B wird über das Kommunikationsmodul 13 ein Ladevorgang initialisiert. Dem Elektrofahrzeug 1 wird damit vorgespielt, dass ein Ladegerät an der Ladebuchse 7 angeschlossen ist. Hierfür kann die Steuereinheit 16 dem Kommunikationsmodul 13 einen entsprechenden Befehl geben. Das Kommunikationsmodul 13 erzeugt die vorgesehenen standardisierten Nachrichten gemäß dem vorgesehenen Ablauf, um das vorgesehene Ladeprototoll zu initialisieren. Falls für das Initialisieren eines Ladevorganges auch eine anliegende Ladespannung an den Ladespannungskontakten DC+, DC- notwendig ist, erzeugt das Ladespannungsmodul 14 in einem folgenden Schritt C die benötigte Ladespannung und legt diese an die Ladespannungskontakte DC+, DC- an. Die Steuereinheit 16 kann hierfür die entsprechenden Befehle zum richtigen Zeitpunkt an das Ladespannungsmodul 14 geben.

Das Initialisieren eines Ladevorganges veranlasst das Elektrofahrzeug 1, die Schalter, insbesondere die zweiten Schalter S3, S4, im Hochvolt-Bordnetz 2 zu schließen. Damit ist das Hochvolt-Bordnetz 2 über die Ladespannungskontakte DC+, DC- und dem Referenzspannungskontakt PE (der im Elektrofahrzeug 1 mit dem elektrischer Referenzpunkt 6 des Elektrofahrzeugs 1 verbunden ist) mit dem Messmodul 15 verbunden und das Messmodul 15 kann im Schritt D den für den wirksamen Isolationswiderstand R_{W} zwischen einer Spannungsleitung L+, L- des Hochvolt-Bordnetzes 2 und dem elektrischer Referenzpunkt 6 repräsentativen Messwert bestimmen und an die Steuereinheit 16 übermitteln. Ohne dem Initialisieren eines Ladevorganges, könnte der wirksame Isolationswiderstand R_{W} nicht gemessen werden, weil die Schalter S3, S4 und normalerweise auch S1, S2 offen wären.

Die Messung des wirksamen Isolationswiderstandes R_{W} erfasst damit den Zustand der elektrischen Isolation an der Speicherbatterie 3, falls die Schalter S1, S2 für den Ladevorgang ebenfalls geschlossen sind, als auch den Zustand von an das Hochvolt-Bordnetz 2 angeschlossenen Verbrauchern Vn. Hierbei wird der Gesamtisolationswiderstand gemessen und es kann nicht auf einzelne Ursachen für eine verschlechterte Isolation geschlossen werden. Das ist aber für den Zweck der regelmäßigen Überprüfung des Isolationswiderstandes des Hochvolt-Bordnetzes 2 eines Elektrofahrzeugs 1 in einer Werkstätte hinreichend.

Falls für die Initialisierung des Ladevorgangs eine Ladespannung an die Ladespannungskontakte DC+, DC- angelegt wurde, so wird die angelegte Ladespannung vor der Messung des wirksamen Isolationswiderstandes R_{W} wieder weggeschaltet. Dann liegt an den Ladespannungskontakten DC+, DC- die Batteriespannung V_{bat} an und der wirksamen Isolationswiderstand R_{W} kann mit der Batteriespannung V_{bat} gemessen werden. Das kann beispielsweise auch im Schritt C erfolgen und kann von der Steuereinheit 16 entsprechend gesteuert werden.

Grundsätzlich könnte man den wirksamen Isolationswiderstand R_{W} auch mit angelegter Ladespannung messen. Hierbei müsste man die Ladespannung zur Messung des wirksamen Isolationswiderstandes R_{W} nicht wegschalten. Allerdings müsste man berücksichtigen, dass sich in diesem Fall zwei Spannungsquellen (Speicherbatterie 3, Ladespannungsmodul 14), bzw. deren Spannungen, überlagern. Das kann zu verzerrten Messungen oder zu anderen unbeabsichtigten Effekten führen, weshalb es vorteilhaft und einfacher ist, die Ladespannung gegebenenfalls vor der Messung wegzuschalten und dann mit der Batteriespannung V_{bat} zu messen.

Das Wegschalten der Ladespannung unterbricht nicht sofort den Ladevorgang im Elektrofahrzeug 1, was für die Messung des wirksamen Isolationswiderstandes R_{W} (was ohnehin sehr schnell erfolgen kann) ausgenutzt werden kann. Insbesondere werden dabei nicht sofort die Schalter Sm geschlossen. Bedarfsweise kann über das Kommunikationsmodul 13 dem Elektrofahrzeug 1 auch signalisiert werden, dass der Ladevorgang noch nicht zu Ende ist.

Ein fahrzeugseitiges Isolationsüberwachungsgerät IMD ist standardmäßig im Ladevorgang deaktiviert. Damit kann das IMD die externe Messung des wirksamen Isolationswiderstand R_{W} nicht beeinflussen.

Die Erfindung nutzt damit einen simulierten Ladevorgang für die Messung des gemessenen wirksamen Isolationswiderstandes R_{W} im Hochvolt-Bordnetz 2 des Elektrofahrzeugs 1. Für diese Messung muss am Elektrofahrzeug 1 nichts umgebaut oder eingebaut werden, sondern es kann ein zur Ladebuchse passender standardisierter Ladestecker des Elektrofahrzeugs 1 verwendet werden. Das macht die Messung zum einen auch sicher, weil Berührschutz gegeben ist, und zum anderen auch ausgesprochen einfach.

Die erfindungsgemäße Messung des wirksamen Isolationswiderstandes R_{W} erfolgt am Beispiel des DC-Ladens, wie bei reinen Elektrofahrzeugen üblich. Bei Hybridfahrzeugen ist oftmals das Laden über eine AC-Spannung und einem fahrzeugseitigen Ladewechselrichter (On Board Charger) vorgesehen. Der Ladewechselrichter würde an sich verhindern, dass der wirksame Isolationswiderstand des Hochvolt-Bordnetzes des Elektrofahrzeuges 1 von außen gemessen werden kann, weil der Ladewechselrichter zwischen dem Bordnetz und der Ladebuchse angeordnet ist. Falls es eine Möglichkeit gibt, den Ladewechselrichter für die Messung des wirksamen Isolationswiderstandes R_{W} zu überbrücken, könnte dieser aber auch in einem solchen Elektrofahrzeug 1 erfindungsgemäß gemessen werden. In diesem Fall würde natürlich auch eine Ladebuchse 7 und zugehöriger Ladestecker 8 mit anderer Kontaktbelegung verwendet werden. Insbesondere würde anstelle des erstes Ladespannungskontakts DC+ und zweiten Ladespannungskontakts DC- für das DC-Laden, Ladespanungskontakte für das AC-Laden vorgesehen sein, wie zumindest ein Phasenleiter L1, L2, L3 und ein Nullleiter N (nicht dargestellt).

Nach der Messung des wirksamen Isolationswiderstand R_{W}, was in der Regel sehr schnell durchgeführt werden kann, wird der vorgespielte Ladevorgang vorzugsweise gemäß dem vorgegebenen Ladeprotokoll beendet. Hierfür kann das Kommunikationsmodul 13, beispielsweise angesteuert durch die Steuereinheit 16, die vorgesehenen Nachrichten an das Elektrofahrzeug 1 senden und/oder erhaltene Nachrichten verarbeiten. Wenn der Ladevorgang nicht durch das Messgerät 10 beendet wird, sondern beispielsweise nach der Messung einfach der Ladestecker 8 entfernt wird, dann wird das Elektrofahrzeug 1 nach einer bestimmten Zeitdauer oder bei der Inbetriebnahme selbst den Ladevorgang verlassen und die Schalter Sj wieder öffnen.

Mit dem Messgerät 10 kann noch eine weitere oftmals vorgesehene Messung durchgeführt werden. Um Feuchtigkeitsprobleme an der Ladebuchse 7 eines Elektrofahrzeugs 1 zu erkennen, wird oftmals vor dem initialisierten Ladevorgang eine Isolationsmessung an der Ladebuchse 7 durchgeführt. Hierzu sind die Schalter S3, S4, die die Ladebuchse 7 mit dem Hochvolt-Bordnetz 2 verbinden, geöffnet. Dann kann ein Isolationswiderstand zwischen zumindest einem, vorzugsweise zwischen jedem, Ladespannungskontakt der Ladebuchse 7, DC+, DCbei DC-Laden oder L1, L2 L3, N (nicht dargestellt) bei AC-Laden, und dem Referenzspannungskontakt PE gemessen werden.

## Patentansprüche

1. Verfahren zur Durchführung einer Messung eines wirksamen Isolationswiderstandes (R_{w}) eines Hochvolt-Bordnetzes (2) eines Elektrofahrzeugs (1), umfassend die folgenden Schritte:
- Stecken eines Ladesteckers (8) eines Messgeräts (10) in eine Ladebuchse (7) des Elektrofahrzeugs (1),
- Initialisieren eines Ladevorganges des Elektrofahrzeugs (1) durch das Messgerät (10), und nach dem Initialisieren des Ladevorganges,
- Messen des wirksamen Isolationswiderstandes (R_{w}) zwischen zumindest einem Ladespannungskontakt (DC+, DC-) des Ladesteckers (7) und einem Referenzspannungskontakt (PE) des Ladesteckers mit dem Messgerät (10).

2. Verfahren nach Anspruch 1, **dadurch gekennzeichnet, dass** der Ladevorgang über Steuerkontakte (PP, CP) am Ladestecker (8), die durch Stecken des Ladesteckers (8) in die Ladebuchse (7) mit Steuerkontakten (PP, CP) der Ladebuchse (7) verbunden werden, und einem vorgegebenen Ladeprotokoll initialisiert wird.

3. Verfahren nach Anspruch 1 oder 2, **dadurch gekennzeichnet, dass** zum Initialisieren des Ladevorganges zusätzlich eine Ladespannung (V_{L}) zwischen einem ersten Ladespannungskontakt (DC+) und einem zweiten Ladespannungskontakt (DC-) des Ladesteckers (8) angelegt wird.

4. Verfahren nach Anspruch 3, **dadurch gekennzeichnet, dass** die Ladespannung (V_{L}) vor dem Messen des wirksamen Isolationswiderstandes (R_{w}) weggeschaltet wird.

5. Verfahren nach Anspruch 1, **dadurch gekennzeichnet, dass** vor dem Initialisieren des Ladevorganges ein wirksamer Isolationswiderstandes (R_{w}) zwischen zumindest einem Ladespannungskontakt (DC+, DC-) des Ladesteckers (7) und einem Referenzspannungskontakt (PE) des Ladesteckers (8) gemessen wird.

6. Anordnung zum Messen eines wirksamen Isolationswiderstandes (R_{w}) eines Hochvolt-Bordnetzes (2) eines Elektrofahrzeugs (1), bestehend aus dem Elektrofahrzeug (1) mit einer Ladebuchse (7) und einem Messgerät (10) mit einem Ladestecker (8), wobei der Ladestecker (8) in die Ladebuchse (7) gesteckt ist, wobei im Messgerät (10) eine Messeinheit (11) mit einem Kommunikationsmodul (13) und einem Messmodul (15) vorgesehen ist, wobei das Kommunikationsmodul (13) vorgesehen ist, am Elektrofahrzeug (1) einen Ladevorgang zu initialisieren, und das Messmodul (15) vorgesehen ist, nach dem Initialisieren des Ladevorganges den wirksamen Isolationswiderstand (R_{w}) zwischen zumindest einem Ladespannungskontakt (DC+, DC-) des Ladesteckers (8) und einem Referenzspannungskontakt (PE) des Ladesteckers zu messen.

7. Anordnung nach Anspruch 6, **dadurch gekennzeichnet, dass** in der Messeinheit (11) zusätzlich ein Ladespannungsmodul (14) vorgesehen ist, das eingerichtet ist, zum Initialisieren des Ladevorganges eine Ladespannung (V_{L}) zwischen einem ersten Ladespannungskontakt (DC+) und einem zweiten Ladespannungskontakt (DC-) des Ladesteckers (8) anzulegen.
